Europäisches Patentamt

European Patent Office

Office européen des brevets

(11) Publication number: **0 320 273**
**A1**

# EUROPEAN PATENT APPLICATION

(21) Application number: **88311656.8**

(22) Date of filing: **09.12.88**

(51) Int. Cl.⁴: **H01L 27/06**

(30) Priority: **11.12.87 JP 314583/87**

(43) Date of publication of application:
**14.06.89 Bulletin 89/24**

(84) Designated Contracting States:
**DE FR GB**

(71) Applicant: **Matsushita Electronics Corporation**
**1006, Oaza-Kadoma Kadoma-shi**
**Osaka 571(JP)**

(72) Inventor: **Tanabe, Kenzo**
**8-10, 3-chome, Yamate Hosida**
**Katano Osaka(JP)**
Inventor: **Asada, Hidetsugu**
**Ebisugawa-agaru Gokoumachidouri**
**Nakagyou-ku Kyoto Kyoto(JP)**
Inventor: **Sato, Hiroaki**
**2-13-19, Akutagawa-cho**
**Takatsuki Osaka(JP)**
Inventor: **Nishijima, Masayuki**
**1-904, 9 banchi Tsubushi Nagitsujinishi**
**Yanasguba-ku Kyoto Kyoto(JP)**
Inventor: **Mizutani, Shiro**
**46-8, Yayoigaoka-cho**
**Takatsuki Osaka(JP)**
Inventor: **Shogaki, Toshihiro**
**1-4-20, Magami-cho**
**Takatsuki Osaka(JP)**

(74) Representative: **Crawford, Andrew Birkby et al**
**A.A. THORNTON & CO. Northumberland**
**House 303-306 High Holborn**
**London WC1V 7LE(GB)**

(54) **Bi-mos semiconductor device.**

(57) This invention relates to a Bi-MOS semiconductor device forming a bipolar circuit and a MOS circuit on a single silicon substrate, in which a buried layer is formed beneath the epitaxial layer composing the MOS circuit, and this buried layer is connected to a power supply having a higher or lower potential than the potential of the silicon substrate and a low impedance. In this constitution, the buried layer can function as an equivalent earth shield. Accordingly, the mutual interference between the diffusion region of the MOSFET and the buried layer formed beneath the epitaxial layer for the bipolar circuit is lessened, and high frequency leak current can hardly flow. As a result, the chip size can be shrinked without adversely affecting the circuit characteristics.

# BI-MOS SEMICONDUCTOR DEVICE

This invention relate to a Bi-MOS semiconductor device having a bipolar circuit and a MOS circuit formed on one semiconductor substrate.

Recently the degree of integration is becoming higher and higher in semiconductor integrated circuits in order to cope with the trend of shrinkage of chip size, lower cost and higher function of appliances. Generally, electronic circuits are classified into linear circuits and digital circuits, and the above object is often achieved by forming the both on one semiconductor substrate. Accordingly, a Bi-MOS semiconductor device utilizing both the bipolar semiconductor technology for realizing linear circuit and the MOS semiconductor technology realizing digital circuit is often used for such electronic circuit.

When composing the MOS type semiconductor part of Bi-MOS semiconductor apparatus by the so-called CMOS, it is a general practice to mutually connect the gate electrodes and drain electrodes of N-channel MOS FET (called N-ch MOSFET hereinafter) and P-channel MOS FET (called P-ch MOSFET hereinafter) so as to use as CMOS inverter. In such constitution, the drain region of P-ch MOSFET and the N-type buried layer forming the collector region of bipolar NPN transistor are mutually capacitively coupled together by way of the PN junction depletion layer through P-type substrate and N-type epitaxial layer.

Therefore, for example, when a logic circuit is composed in the CMOS part and an amplification circuit for amplifying a small amplitude signal by bipolar NPN transistor, the pulse edge signal of logic circuit leaks to the collector of the NPN transistor, and the normal amplification action is impeded.

Conventionally, in such Bi-CMOS semiconductor device, the N-type epitaxial layer and P-type substrate are used as being connected, locally, to a low impedance power source potential and earth potential, but since the intrinsic resistance of the epitaxial layer and substrate is high, it is difficult to notably improve the problems occuring due to the above capacitive coupling.

It is hence a primary object of this invention to present a Bi-MOS semiconductor device capable of reducing the mutual interference between MOS circuit and bipolar circuit.

It is a second object of this invention to present a Bi-MOS semiconductor device capable of shrinking the chip size without adversely affecting the circuit characteristics by reducing the mutual interference of MOS circuit and bipolar circuit.

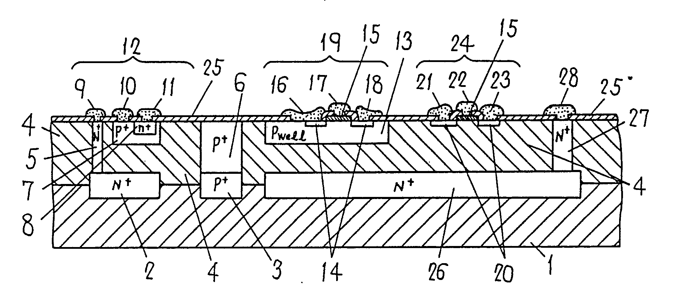

These and other objects will be better understood and appreciated from the following detailed description taken in conjunction with the attached drawing.

In sum, this invention presents a Bi-MOS semiconductor device in which a first buried layer of a certain conductive type is formed on a silicon substrate of a different conductive type, an epitaxial layer of a different conductive type from the silicon substrate is formed on an upper layer of the first buried layer, and a bipolar circuit is formed in this epitaxial layer, a second buried layer of a different conductive type from the silicon substrate is formed in other area on the silicon substrate separated from the above bipolar circuit portion by a device separation region, an epitaxial layer of a different conductive type from the silicon substrate is formed on the upper layer of this second buried layer, a MOS circuit is formed in this epitaxial layer, and the second buried layer is connected to a power supply which is either higher or lower in potential than that of the silicon substrate and has a low impedance.

The drawing is a sectional view showing a Bi-MOS semiconductor device in one of the embodiments of the invention.

The Bi-MOS semiconductor device in one of the embodiments of this invention is described below while referring to the accompanying drawing.

In the drawing, a first N-type buried layer 2 and a P-type buried layer 3 for device separation are formed on a P-type substrate 1, and an N-type epitaxial layer 4 is formed on the substrate 1 covering those buried layers 2, 3. In the epitaxial layer 4 on the N-type buried laer, an N-type high conductive layer 5 called collector wall is formed. In the epitaxial layer 4 on the P-type buried layer 3, a P-type high conductive layer 6 for device separation is formed. In the part of the N-type epitaxial layer 4 separated by the P-type buried layer 3 and P-type high conductive layer 6, a P-type base diffusion layer 7 is formed. In the P-type base diffusion layer 7, an N-type emitter difussion layer 8 is formed. The N-type high conductive layer 5, P-type base diffusion layer 7, and N-type emitter diffusion layer 8 are respectively connected with collector electrode 9, base electrode 10, and emitter electrode 11, and a bipolar NPN transistor is composed of these parts. On the other hand, a P-well 13 composed of P-type diffusion layer is formed in another part of the N-type epitaxial layer 4 separated by the P-type buried layer 3 and P-type high conductive layer 6. In the P-well 13, a source region 14 and a drain region 14 made of N-type diffusion layer are formed, and a gate oxide film 15 is disposed between them. On the source region 14, gate oxide film 15 and drain region 14 source electrode 16, gate electrode 17 and drain electrode 18 are respectively formed, and an N-ch MOSFET 19 is composed of these parts. In the N-type epitaxial layer 4 adjacent to the P-well 13, a source region 20 and a drain region 20 mode of P-type diffusion layer are formed, and a gate oxide film 15 is formed between them. On the source region 20, gate oxide film 15 and drain region 20, source electrode 21, gate electrode 22 and drain electrode 23 are respectively formed, and a P-ch MOSFET 24 are made of these parts. An insulation film 25 is formed on the surface of the N-type epitaxial layer 4, excluding the electrodes 9 to 11, 16 to 18, and 21 to 23.

So far, the composition is the same as in the conventional Bi-MOS semiconductor device. As stated above, in this constitution, the drain region 20 of the P-ch MOSFET 24 and the first N-type buried layer 2 forming the collector region of the NPN transistor 12 are mutually capacitively coupled by a depletion layer of PN junction through P-type substrate 1 and N-type epitaxial layer 4. As a result, a leak current is likely to flow from the source region 20 in the P-ch MOSFET 24 toward the N-type buried layer 2 of the NPN transistor 12.

In this embodiment, therefore, a second N-type buried layer 26 is formed in an almost entire area beneath the N-type epitaxial layer 4 in which N-ch MOSFET 19 and P-ch MOSFET 24 are formed. The second N-type buried layer 26 is formed in the same process as the first N-type buried layer 2 forming the collector region of the bipolar NPN transistor 12. In the N-type epitaxial layer 4 on the second N-type buried layer 26, an N-type high conductive layer 27 for appying a specific potential to the second N-type buried layer 26 is formed. This N-type high conductive layer 27 is formed in the same process as the N-type high conductive layer 5 of the bipolar transistor 12. An electrode 28 is connected to the N-type high conductive layer 27. The electrode 28 is connected to a power supply (not shown) which has low impedance and a higher potential than that of the P-type substrate 1.

In this constitution, through the electrode 28 and N-type high conductive layer 27, the second N-type buried layer 26 is connected to the power supply which has low impedance and a higher potential than that of the P-type substrate 1. As a result, the second N-type buried layer 26 equivalently functions as an earth shield layer. Accordingly, the capacitive coupling between the drain region 20 of the P-ch MOSFET 24 and the first N-type buried layer 2 is greatly reduced, and the high frequency leak current flowing from the drain region 20 of the P-ch MOSFET 24 toward the first N-type buried layer 2 can be notably decreased. Therefore, in case that, for example, a small signal amplification circuit is composed by bipolar transistors and a logic circuit is composed by CMOS part, it is possible to realize a one-chip semiconductor integrated circuit being free from mutual interference if the both circuits operate at the same time.

In the foregoing explanation, meanwhile, a simple embodiment is illustrated in order to clarify the nature of the invention, but this invention may be applied, needle to say, also by introducing the integrated circuit technology employed individually in the conventional bipolar integrated circuit or MOS integrated circuit, for example, the P-type separation diffusion layer for separating the devices securely, introducing the selective oxidation region for MOS type device separation, introducing the separation diffusion layer for separating the bipolar circuit region and MOS circuit region.

Besides, the P-type silicon substrate is used in the above embodiment, but, as a matter of course, the concept of this invention may be also applied to the N-type silicon substrate. In such a case, the second buried layer disposed beneath the MOS circuit portion is connected to a power supply having a lower potential than the N-type silicon substrate.

Thus, in this invention, a second buried layer is formed almost in an entire region of the lower layer of the region forming the MOS transistor circuit part in the Bi-MOS semiconductor device, and by utilizing this second buried layer as an equivalent earth shield layer, the mutual interference of the circuit part composed of bipolar transistor and the circuit part composed of MOS transistor can be eliminated, and a practical Bi-MOS semiconductor device can be realized.

## Claims

1. A Bi-MOS semiconductor device comprising: a silicon substrate of a certain conductive type; a first buried layer of a reverse conductive type of said silicon substrate being formed on said silicon substrate; a first epitaxial layer of a reverse conductive type of said silicon substrate being formed on said buried layer; a bipolar circuit formed in said first epitaxial layer; a second buried layer of a reverse conductive type of said silicon substrate being formed on said silicon substrate separated from said bipolar circuit by a device separating region; a second epitaxial layer of a reverse conductive type of said silicon substrate being formed on the second buried layer; a MOS circuit formed in said second epitaxial layer and above the region of said second buried layer; and

means for connecting said second buried layer to a power supply having a higher or lower potential than the potential of said silicon substrate and a low impedance.

2. A Bi-MOS semiconductor device according to claim 1, wherein a high conductive layer having an identical conductive type of said second buried layer, penetrating through said second epitaxial layer, with one end connected to said second buried layer and the other end connected to an electrode, is formed in said second epitaxial layer, and said second buried layer is connected to said power supply by way of said electrode and said high conductive layer.

3. A Bi-MOS semiconductor device according to claim 1, wherein the MOS circuit is compsed of CMOS circuit containing N-channel MOSFET and P-channel MOSFET.

4. A Bi-MOS semiconductor device according to claim 3, wherein a CMOS inverter is composed by mutually connecting the gate electrodes and drain electrodes of said N-channel MOSFET and P-channel MOSFET in said CMOS circuit, and an amplification circuit for amplifying a small amplitude signal is composed of said bipolar circuit.

5. A method for fabrication of a Bi-MOS semiconductor device comprising:
a first step of forming, on a silicon substrate of a certain conductive type, first and second buried layers of a reverse conductive type of said silicon substrate at the same process;
a second step of forming an epitaxial layer of a reverse conductive type of said silicon substrate on said first and second buried layers;
a third step of forming a device separating region in said epitaxial layer in the boundary area of said first and second buried layers in order to separate said epitaxial layer into a first epitaxial layer on said first buried layer and a second epitaxial layer on said second buried layer;
a fourth step of forming a bipolar circuit in said first epitaxial layer;
a fifth step of forming a MOS circuit in said second epitaxial layer and above the region of said second buried layer; and
a sixth step of connecting said second buried layer to a power supply having a higher or lower potential than the potential of said silicon substrate and a low impedance.

6. A mehtod for fabrication of a Bi-MOS semiconductor device according to claim 5 further comprising:
a seventh step of forming a first high conductive layer of the same conductive type as said first buried layer, penetrating through said first epitaxial layer, with one end connected to said first buried layer and the other end connected to an electrode;
an eighth step of forming a second high conductive layer of the same conductive type as said second buried layer, penetrating through said second epitaxial layer, with one end connected to said second buried layer and the other end connected to an electrode, in the same process as said seventh step; and
a nineth step of connecting said second buried layer to a power supply having a higher or lower potential than the potential of said silicon substrate and a low impedance, through said second high conductive layer and said electrode connected to said high conductive layer.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.3) |
|---|---|---|---|
| X | US-A-4 646 124 (M.J. ZUNINO)<br>* Figures, whole document *<br>----- | 1-6 | H 01 L 27/06 |

|  |  |  | TECHNICAL FIELDS SEARCHED (Int. Cl.3) |
|---|---|---|---|
|  |  |  | H 01 L 27/06 |

The present search report has been drawn up for all claims

| Place of search | Date of completion of the search | Examiner |
|---|---|---|
| BERLIN | 28-02-1989 | JUHL A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)